# EUROPÄISCHE PATENTSCHRIFT

(11) **EP 0 705 530 B1**
(45) Veröffentlichungstag und Bekanntmachung des Hinweises auf die Patenterteilung: **27.12.1996**
(21) Anmeldenummer: 94911097.7
(22) Anmeldetag: 31.03.1994
(51) Int. Cl.: H05K 7/20, H01L 23/473

(54) **STROMRICHTERMODUL**
CONVERTER MODULE
MODULE CONVERTISSEUR

(30) Priorität: 24.06.1993 DE 9309428 U
(43) Veröffentlichungstag der Anmeldung: 10.04.1996
(73) Patentinhaber: SIEMENS AKTIENGESELLSCHAFT, 80333 München (DE)
(72) Erfinder: IMRICH, Johann, D-91056 Erlangen (DE); FÜHRER, Wolfgang, D-91074 Herzogenaurach (DE); PAPP, György, D-91056 Erlangen (DE); MARQUARDT, Rainer, D-91074 Herzogenaurach (DE); KAISER, Hans, D-91074 Herzogenaurach (DE)
(86) Internationale Anmeldenummer: DE9400365
(87) Internationale Veröffentlichungsnummer: WO9501088

(56) Entgegenhaltungen:
- EP-A- 0 446 836
- EP-A- 0 514 141
- DE-A- 2 128 454
- FR-A- 2 335 049
- ELEKTRISCHE BAHNEN, März 1993, MUNCHEN DE Seiten 87 - 93 MATTHIAS JUNG 'Hochleistungsstromrichter für Bahnen' in der Anmeldung erwähnt
- ELEKTRISCHE BAHNEN, März 1993, München, DE, SS 87-93; MATTHIAS JUNG: 'Hochleistungsstromrichter für Bahnen'

## Beschreibung

Die Erfindung bezieht sich auf ein Stromrichtermodul mit einem metallischen allseitig geschlossenen Gehäuse, in dem Stromrichterventile sowie Beschaltungskomponenten, wie Drosseln, Kondensatoren und ein Widerstand, angeordnet sind, wobei das Gehäuse mit zwei Anschlüssen für die Zu- und Abführung des Kühlmediums sowie mit mehreren Leistungsanschlüssen versehen ist.

Ein derartiges Stromrichtermodul ist aus der EP 0 446 836 Al bekannt. Beim dort beschriebenen ölgekühlten Traktions-Stromrichter eines Schienenfahrzeugs erfolgt die Isolierung und die Kühlung durch Isolieröl. An der Rückseite dieses Moduls sind die beiden Schnellverschlußkupplungen sowie ein Überstromventil angeordnet, wobei das Überstromventil, das oberhalb eines vorgebbaren, eingestellten Öldrucks Isolieröl aus dem Gehäuseinneren des Moduls in einen an der Rückseite des Gehäuses befindlichen Ölauffangraum leitet. Diese aus Überstromventil und Ölauffangraum bestehende Sicherheitsvorrichtung ist notwendig, um eine bei einem vom externen Ölkreislauf abgekoppelten Stromrichtermodul auftretende Öldruckerhöhung auf ungefährliche Werte zu begrenzen. Der Ölkreislauf dieses Moduls ist derart ausgebildet, daß die temperaturempfindlichen Bauelemente, wie insbesondere die GTO-Thyristoren und Dioden mit noch nicht aufgeheiztem Isolieröl gekühlt, während die weniger temperaturempfindlichen Bauelemente, wie Drosseln, GTO-nahe Beschaltung und Widerstände, mit bereits aufgeheiztem Isolieröl versorgt werden.

Eine derartige Öl-Badkühlung hat sich in Fahrzeugstromrichtern, besonders bei 3-kV-Gleichspannungsbahnen bewährt. Alle verlusterzeugenden Bauteile werden dabei innerhalb eines verschlossenen Gefäßes in einem Flüssigkeitsbad, zum Teil mit Unterstützung durch Kühlkörper, entwärmt. Die Verlustleistung wird umso besser abgeführt, je höher die Strömungsgeschwindigkeit des Bades an der zu kühlenden Fläche ist. Deshalb muß durch Pumpen Strömungsgeschwindigkeit erzeugt werden. Die Pumpen und schließlich auch die Öl-Rückkühler müssen außerhalb des Gefäßes aufgestellt werden. Das beansprucht Volumen und Gewicht. Die Antriebsleistung der Pumpe belastet außerdem das Fahrzeugbordnetz.

Bei Anwendung dieser Öl-Badkühlung treten folgende Probleme auf:
- Die im Bad liegenden Bauteile müssen mit dem Kühlmittel chemisch langzeitverträglich sein.
- Die elektrischen Anschlüsse müssen elektrisch isoliert und öldicht durch den Behälterdeckel geführt werden.
- Lichtbogen, die in Störungsfällen im Gefäßinneren auftreten können, müssen beherrschbar sein.
- Bauteiltausch muß möglichst einfach durchführbar sein, bzw. durch gesteigerte Zuverlässigkeit unnötig werden.

Die Öl-Badkühlung erfüllt zwar die Forderung nach umfassendem Verschmutzungsschutz, befriedigt aber bei Volumen und Gewicht nicht in allen Fällen.

Eine weitere Kühlungsart ist die sogenannte Dosenkühlung. Bei dieser Dosenkühlung werden die verlusterzeugenden Bauteile mit von Flüssigkeit durchströmten Kühldosen entwärmt, womit auch eine sehr gute thermische Wirksamkeit erreicht wird. Weniger gut bis unmöglich ist die Kühlung anderer Bauelemente auf diesem Wege. Dazu zählen Widerstände, Kondensatoren, Stufenkerne usw., so daß man dort wieder auf Luftkühlung angewiesen ist. Die gewünschte vollständige Kapselung gelingt damit nicht. Die Dosenkühlung bleibt daher bezüglich des Verschmutzungsschutzes ein Kompromiß.

Wasser ist durch die Kombination seiner Eigenschaften bezüglich Dichte, Wärmeleitfähigkeit und spezifischer Wärme ein ideales Kühlmedium. Wenn elektrische Potentiale vom Kühlkreislauf getrennt sein müssen, stellt die elektrische Leitfähigkeit des unbehandelten Wassers oft ein Hindernis gegen die Verwendung als Kühlmittel dar.

In der Zeitschrift "eb-Elektrische Bahnen", 91 (1993) 3, Seiten 87 bis 93 wird eine isolierte Wasserkühlung eines Stromrichters im einzelnen dargestellt. Das wassergekühlte Phasenmodul enthält zwei GTO-Thyristoren mit ihren Freilaufdioden und die zugehörige Zweigpaarbeschaltung. Die stromanstiegsbegrenzende Induktivität ist aus Gewichtsgründen nicht in das Modul integriert. Die wassergekühlten Entladewiderstände der Beschaltung, in denen abhängig vom Arbeitspunkt erhebliche Verlustleistung bis zu 7 kW anfällt, werden außerhalb des Moduls aufgebaut. Alle Leistungskreisverbindungen innerhalb des Moduls sind auf kurzem Wege mit optimierten Stromschienen hergestellt, um minimale Strominduktivitäten zu erhalten. Da alle Komponenten gut zugänglich sein sollen, ist das Phasenmodul als offener Rahmen aufgebaut. Bei dieser isolierten Wasserkühlung gelangt die Wärme von dem zu kühlenden Leistungshalbleiter über Isolierzellen und Kühldosen in den Wasserkreislauf. Weitere Komponenten wie Beschaltungswiderstände und Phasendrosseln können seriell oder parallel dazu an den Kreislauf angeschlossen werden. Eine Umwälzpumpe fördert das Wasser zum Rückkühler, der als Wasser/Luft-Wärmetauscher arbeitet.

Die Wasserkühlung ist genauso effektiv wie die Siede-Badkühlung und erzielt Wärmeübergangskoeffizienten, die um ein Vielfaches größer sind, als bei einer Öl-Badkühlung. Während es sich bei der Anwendung von Wasser oder Öl als Zwischenkühlmittel im Rahmen der zulässigen Temperaturen immer um einphasige Zustände des Kühlmediums handelt, bewegt es sich bei der Siedekühlung zwischen den Phasen "flüssig" und "Dampf". Durch den Übergang vom Aggregatszustand "flüssig" in "Dampf" mittels der Verlustleistung der Elemente eines Siedebad-Moduls werden außerordentlich hohe Wärmeübergangszahlen erreicht, die von der Dosenkühlung ebenfalls erreicht werden.

Der Erfindung liegt nun die Aufgabe zugrunde, ein Stromrichtermodul der eingangs genannten Art anzugeben, das als Kühlmedium Wasser verwendet, wobei die Probleme der Dosenkühlung nicht mehr auftreten.

Diese Aufgabe wird in Verbindung mit den Merkmalen des Oberbegriffs erfindungsgemäß durch die im Kennzeichen des Anspruchs 1 angegebenen Merkmale gelöst.

Durch die erfindungsgemäße Ausgestaltung des Gehäuses dient dieses als tragendes Teil, als Montagerahmen für die Spannverbände und als Kühlkörper. Durch die Abdeckung ist das Modul spritzwasser und staubdicht gekapselt. Außerdem enthält dieses Gehäuse alle Bauteile für eine Stromrichter-Phase, so daß sich der Stromrichteraufbau weiter vereinfacht.

Die mit der Erfindung erzielbaren Vorteile bestehen insbesondere darin, daß die Kühl- und Gesamtleistung des Stromrichtermoduls bei gleichzeitiger Senkung des Gewichts und des Volumens wesentlich verbessert wird, wodurch sich die Hantierbarkeit vereinfacht, daß kein Fluorkohlenwasserstoff als Kühlmedium mehr verwendet wird, wodurch keine Umweltbelastung mehr auftritt, und daß aufwendige und schwere Luftführungskanäle wegfallen, da die temperaturunempfindlichen Bauelemente, wie Kondensatoren und Widerstände, mittels von kühlflüssigkeitsdurchströmten Kühlkanalplatten entwärmt werden.

Vorteilhafte Ausgestaltungen der Erfindung sind in den Unteransprüchen gekennzeichnet.

Zur weiteren Erläuterung wird auf die Zeichnung Bezug genommen, in der ein Ausführungsbeispiel eines erfindungsgemäßen Stromrichtermoduls schematisch dargestellt ist.

- Figur 1: zeigt ein erfindungsgemäßes Stromrichtermodul von links, in
- Figur 2: ist das Blockschaltbild der verwendeten Stromrichterschaltung des Stromrichtermoduls dargestellt,
- Figur 3: zeigt das elektrische Ersatzschaltbild der Stromrichterschaltung nach Figur 2, wobei die
- Figur 4: den Wasserkühlkreislauf veranschaulicht, die
- Figur 5: zeigt das Stromrichtermodul von links ohne Leistungsanschlüsse, wobei mittels Pfeilen der Kreislauf des Kühlmediums veranschaulicht ist,
- Figur 6: zeigt eine teilweise geschnittene Ansicht der Vorderseite des Moduls,
- Figur 7: zeigt eine teilweise geschnittene Ansicht der Oberseite des Moduls, und in
- Figur 8: ist eine Ansicht der Innenseite der Oberseite des Moduls dargestellt.

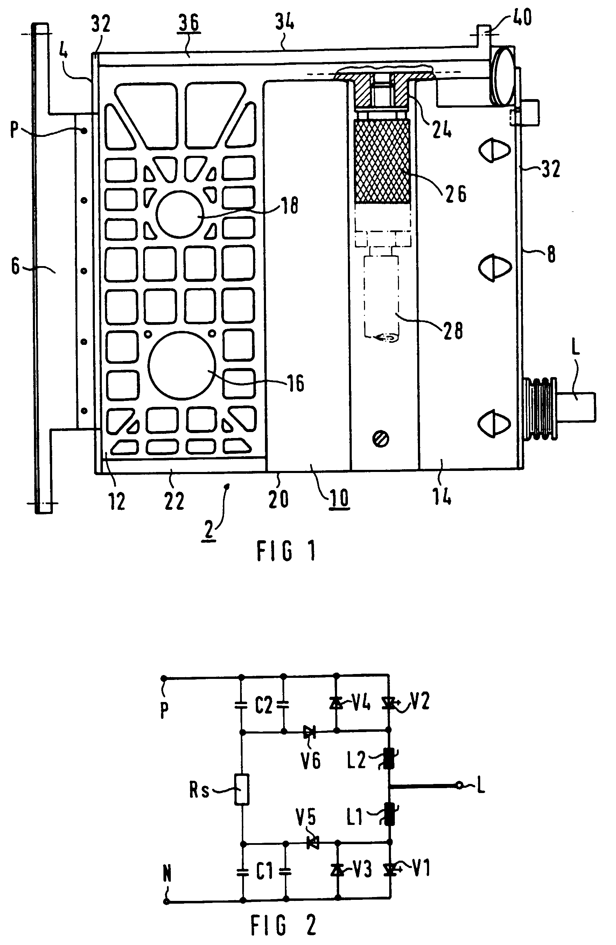

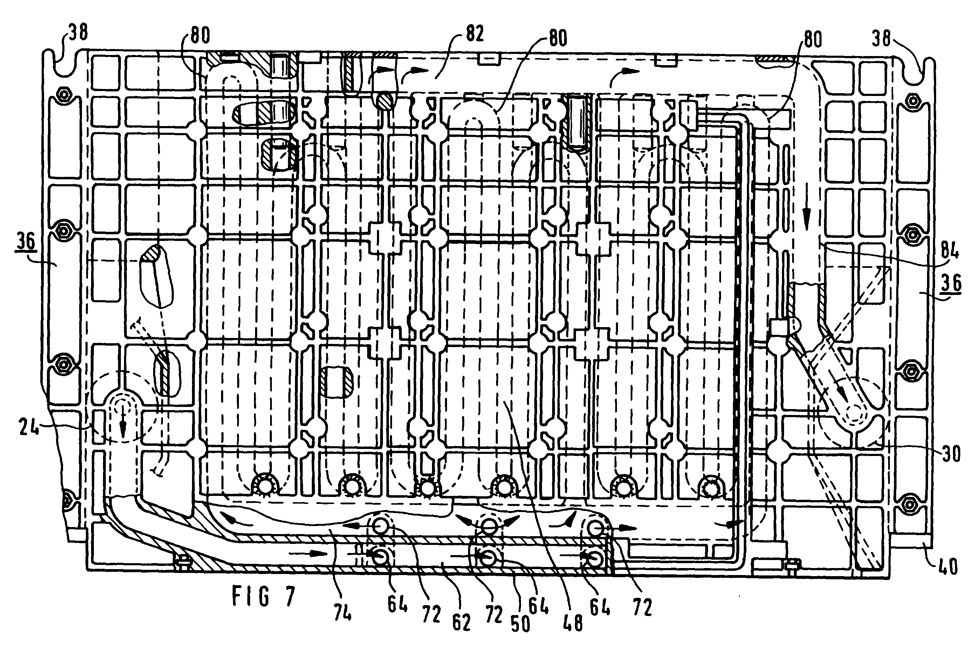

Die Figur 1 zeigt ein Stromrichtermodul von links, das aus einem metallischen allseitig geschlossenen Gehäuse 2 besteht. Auf der Rückseite 4 dieses Gehäuses 2 ragen in der Modulmitte aus dem Gehäuse 2 zwei großflächige Stromschienen P und N heraus, die jeweils mit einem gewinkelten StromschienenAnschlußteil lösbar verbunden sind. Auf der Vorderseite 8 des Gehäuses 2 ist der Leistungsanschluß L zu erkennen. Die Seitenwand 10 ist unterteilt in einen mit Rippen versehenen Bereich 12 und einen Bereich 14, der eine Ausnehmung gestaltet. Im Bereich 12 sind die Aufnahmen 16 und 18 der zwei Spannverbände zu erkennen. An der Unterseite 20 dieses Bereiches 12 ist eine Zugstrebe 22 zur Aufnahme der Zugkraft aus den Spannverbänden vorgesehen. Die Oberseite 34 des Bereichs 12 übernimmt in gleicher Weise wie die Strebe 22 Zugkräfte aus dem Spannverband. Die Rippen dieses Bereiches 12 haben die Aufgabe, die Druckkräfte der Spannverbände auf diesen gesamten Bereich 12 zu verteilen und dienen zur Versteifung des Bereichs 12. Im Bereich 14, der eine Ausnehmung bildet, ist ein Anschluß 24 für die Zu- bzw. Abführung der Kühlflüssigkeit angeordnet. An diesem Anschluß 24 ist ein beidseitig selbstsperrender Schnellverschluß 26 angebracht, an dessen freiem Ende ein Kühlmittelschlauch 28 angeschlossen werden kann. Durch die Ausbildung dieses Bereiches 14 als Ausnehmung sind die Anschlüsse 24 und 30 für die Zu- und Abführung von Kühlflüssigkeit innerhalb des Raumprofils des Moduls angeordnet. Die Seitenwand 10 enthält außerdem Gewindelochbohrnasen für die lösbare Verbindung der Abdeckungen 32, die beispielsweise aus Metall oder Epoxidharz sein können. Auch die Rückseite 4 und die Unterseite 20 sind mit Abdeckungen 32 verschlossen. Die Oberseite 34, die Seitenwände 10 und der überwiegende Teil der Vorderseite 8 bilden einen Gehäuseteil, der beispielsweise als Aluminiumgußteil ausgeführt ist. Die Oberseite 34 des Gehäuses 2 ist beidseitig mit einer Tragschiene 36 versehen, die zur Aufnahme von lösbaren Verbindungselementen mit Bohrungen versehen sind. Außerdem sind die Tragschienen 36 an einem Ende mit einer Zentriervorrichtung 38 (Figur 7) und am anderen Ende mit einer Arretierungsvorrichtung 40 versehen.

Durch die Aufteilung des Gehäuses in einen mehrseitig geöffneten Gehäuseteil und in mehrere Abdeckungen 32 wird eine bessere Zugänglichkeit zum Inneren des Gehäuses 2 erreicht, wodurch die Montage der Stromrichterschaltung sich wesentlich vereinfacht. Mittels der Abdeckung 32 erhält man ein spritzwasserdicht und staubdicht gekapseltes Stromrichtermodul. Außerdem ist dieses Gehäuse 2 des Moduls mechanisch robust. Durch die erfindungsgemäße Ausgestaltung des Gehäuses ist dieses gleichzeitig tragendes Teil, Montagerahmen für die Spannverbände und Kühlkörper in einem. Damit sich im Modul kein feuchtes Kleinklima ausbildet, ist es ratsam, die Vorderseite 8 mit einem kleinem Lüftungsloch zu versehen, welches durch einen herausschraubbaren Luftfilter verschließbar ist. Eine weitere Möglichkeit besteht darin, die Unterseite 20 mit einer Öffnung zu versehen, an der ein langer Schlauch angebracht ist, der als Luftfilter dient und eventuelles Tauwasser oder Leckwasser in einen Auffang leitet.

Die Figur 2 zeigt ein Blockschaltbild einer verwendeten Stromrichterschaltung einer Phase eines Wechselrichters. Eine derartige Stromrichterschaltung ist aus der DE 2 128 454 Al bekannt. Diese Stromrichterschaltung besteht aus zwei Stromrichterventilen V1 und V2, beispielsweise Thyristoren, insbesondere abschaltbare Thyristoren (Gate-Turn-Off-Thyristoren-GTO-Thyristoren). In Serie zu jedem Stromrichterventil V1, V2 ist eine Drossel L1, L2 geschaltet, der ein Widerstand R über zwei Dioden V5 und V6 mit Durchlaßrichtung im Sinne des Drosselstromes parallel geschaltet ist. Außerdem ist jedem Stromrichterventil V1 und V2 über eine der vorangeführten Dioden V5 und V6 ein Kondensator C1 und C2 parallel geschaltet. Ferner ist jedem Stromrichterventil V1 und V2 eine Diode V3 und V4 antiparallel geschaltet. Die Drosseln L1 und L2 schützen die Stromrichterventile V1 und V2 gegen die gefährlichen Folgen von Kurzschlüssen und gegen einen zu großen Stromanstieg (di/dt). Die Kondensatoren C1 und C2 sind zur Begrenzung eines raschen Spannungsanstieges (du/dt) vorgesehen, die mittels der Dioden V5 und V6 an den Stromrichterventilen V1 und V2 angekoppelt sind. Der Widerstand Rs koppelt die beiden Kondensatoren C1 und C2, so daß die Kapazitäten beider Kondensatoren C1 und C2 bei der Spannungsbegrenzung wirksam sind und dieser Widerstand Rs dient zur Umwandlung der in den Drosseln L1 und L2 gespeicherten Energie in Wärme.

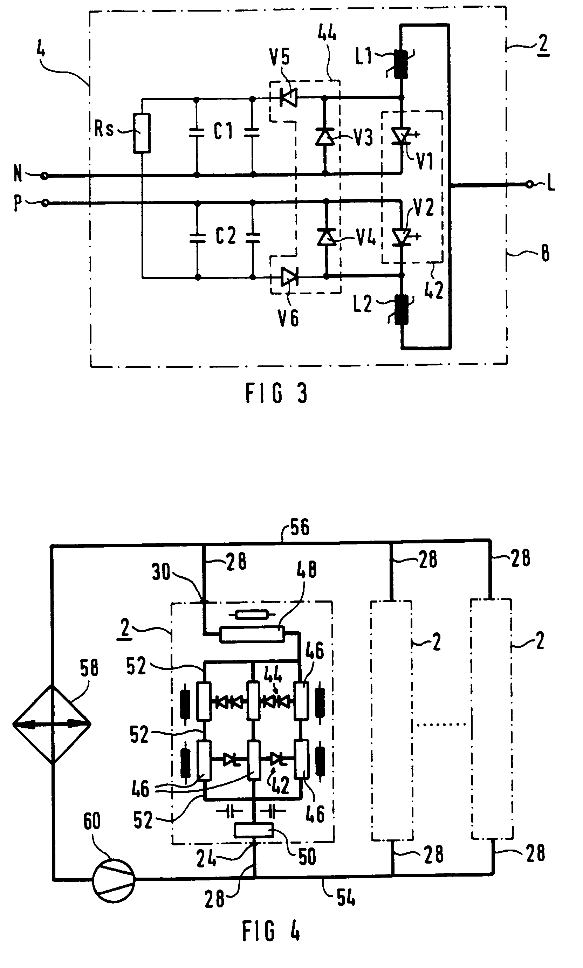

Die Figur 3 zeigt das elektrische Ersatzschaltbild der Stromrichterschaltung nach Figur 2, so wie diese Stromrichterschaltung im Gehäuse 2 des Moduls eingebaut ist. Dieser Figur 3 ist zu entnehmen, daß die beiden Leistungsanschlüsse P und N eng benachbart in der Modulmitte auf der Rückseite 4 des Gehäuses 2 und der Leistungsanschluß L auf der Vorderseite 8 des Gehäuses 2 angeordnet sind. Die Stromrichterventile V1 und V2 bilden einen ersten Spannverband 42 und die Stromrichterventile V3 bis V6 bilden einen zweiten Spannverband 44. Diese beiden Spannverbände 42 und 44 sind übereinander auf Luftstreckenabstand angeordnet. Der Spannverband 42 ist für sehr hohe Spanndrücke (bis 48 kN) ausgelegt, wobei der Spannverband 44 mit ca. 25 kN auf den zulässigen Spanndruck der Beschaltungsdioden V3 bis V6 ausgelegt ist. Der kleinere Spanndruck ist aber für die Dioden V3 bis V6 völlig unproblematisch. Die Beschaltungselemente, wie die Kondensatoren C1, C2 und der Widerstand Rs, der aus einer Vielzahl von Widerständen zusammengeschaltet ist, sind mit ihren Anschlüssen zu den Stromrichterventilen V1, V2 des ersten Spannverbandes 42 gerichtet. Alle modulinternen Verbindungen zwischen den Stromrichtersäulen 42, 44 sowie den Beschaltungskondensatoren C1, C2 werden mittels dünner Kupferbleche, die zwischen Stromrichterventile V1 bis V6 und Kühldosen 46 zwischengelegt sind, hergestellt. Dabei werden die Hin- und Rückleiter dicht aneinandergeführt. Durch die Ausführungsform der Stromrichterschaltung gemäß Figur 3 erhält man eine minimale Anzahl der Verbindungsschienen. Ein wichtiger Vorteil dieser Anordnung besteht darin, daß die Verbindungen großflächig und mit geringem Abstand parallel geführt werden, was zu sehr geringen Streuinduktivitäten führt. Ein Knotenpunkt im Schaltplan nach Figur 3 entspricht einer Stromschiene im Aufbau. Durch die symmetrische Beschaltung erhält man einen symmetrischen Aufbau, wodurch keine Kreuzung der Verbindungsschienen auftritt. Da die Stromschienen zwischen einem Stromrichterventil V1 bis V6 und einer Kühldose 46 geklemmt wird, können dünne Stromschienen verwendet werden, da sie mitgekühlt werden. Zur Potentialtrennung sind zwischen den metallischen Kühldosen 46 und den Scheiben-Leistungshalbleitern V1 bis V6 Keramik-Isolierscheiben aus Aluminiumnitrit gelegt (Durchschlagsfestigkeit > 20 kV/mm). Diese Keramik-Isolierscheiben weisen ebenfalls eine gute Wärmeleitfähigkeit (> 140 W/mK) auf.

Wie der Figur 4 zu entnehmen ist, die den Wasserkühlkreislauf veranschaulicht, enthält der Spannverband 42 und 44 jeweils drei Kühldosen 46. Außerdem ist dieser Figur 4 zu entnehmen, daß die Einzelwiderstände des Widerstandes Rs mittels einer Kühlplatte 48 und die Kondensatoren C1 und C2 mittels einer Kühlplatte 50 entwärmt werden. In den Spannverbänden 42 und 44 sind jeweils die Drosseln L1 und L2 eingespannt, wobei jede Drossel L1 bzw. L2 in zwei Teildrosseln unterteilt ist. Eine derartige Drossel L1 bzw. L2, die einseitig in einem Spannverband 42 und 44 eingespannt werden kann, ist in der EP 0 465 700 B1 ausführlich dargestellt.

Gemäß der Figur 4 ist der Kühlkreislauf folgendermaßen aufgebaut: Die Kühlplatte 50 ist jeweils mittels eines Kühlschlauches bzw. Wasserrohres 52 mit einer Kühldose 46 des ersten Spannverbandes 42 verknüpft. Jede Kühldose 46 des ersten Spannverbandes 42 ist ebenfalls mittels eines Kühlschlauches bzw. Wasserrohres 52 mit einer Kühldose 46 des zweiten Spannverbandes 44 verbunden. Die Kühldosen 46 dieses zweiten Spannverbandes sind jeweils mittels eines Kühlschlauches bzw. Wasserrohres 52 mit der Kühlkanalplatte 48 verknüpft, wobei diese Kühlkanalplatte 48 ausgangsseitig mit einem Anschluß 30 zur Abführung von Kühlflüssigkeit verbunden ist. Die Kühlkanalplatte 50 ist eingangsseitig mit einem Anschluß 24 zur Zuführung von Kühlflüssigkeit verbunden.

Die hohe Leistungsdichte des Stromrichtermoduls erfordert eine intensive Kühlung der Leistungselektronik. Beim erfindungsgemäßen Kühlkonzept werden die Stromrichtermodule mit Wasser gekühlt. Die Module werden dazu mit beidseits schließenden Schnellverschlußkupplungen 26 über Schlauchleitungen 28 an den Wasserkreislauf angeschlossen. Die zur Wasserversorgung notwendigen Verrohrungen - Zu- und Abflußrohr 54 und 56 - sind bereits mit vorbereiteten Anschlüssen für den Wasserzu- und -ablauf im Gerüst installiert. Die Rückkühlung des erwärmten Wassers erfolgt in einem Luft/Wasser-Wärmetauscher 58. Im Zuflußrohr 54 ist eine Pumpe 60 angeordnet, mit der die Kühlflüssigkeit zu den einzelnen Moduln gefördert wird. An dieser Wasserversorgung können bis zu vierzehn Stromrichtermodule angeschlossen werden. Der gesamte Kühlwasserkreislauf ist in sich ein geschlossener Kreislauf. Im Kühlwasser ist ein Frostschutzmittel zugesetzt, das auch den Winterbetrieb bis -30°C ermöglicht.

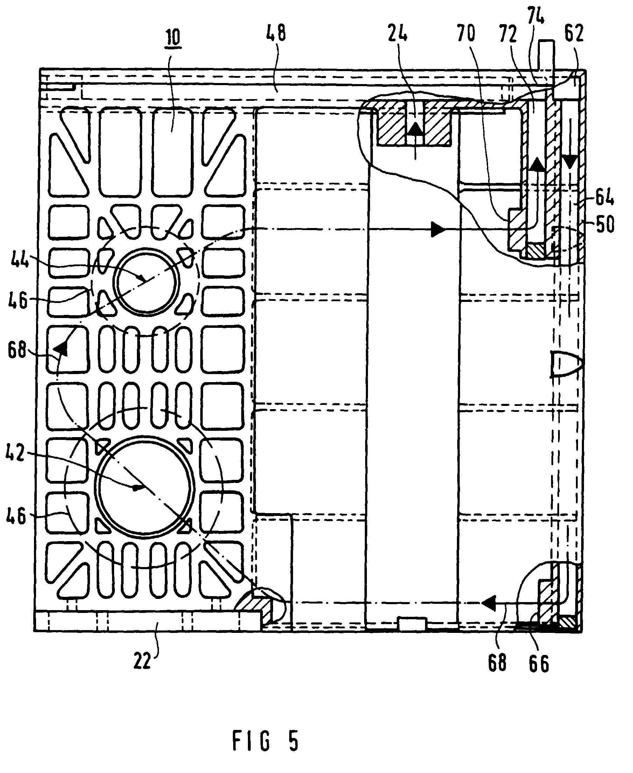

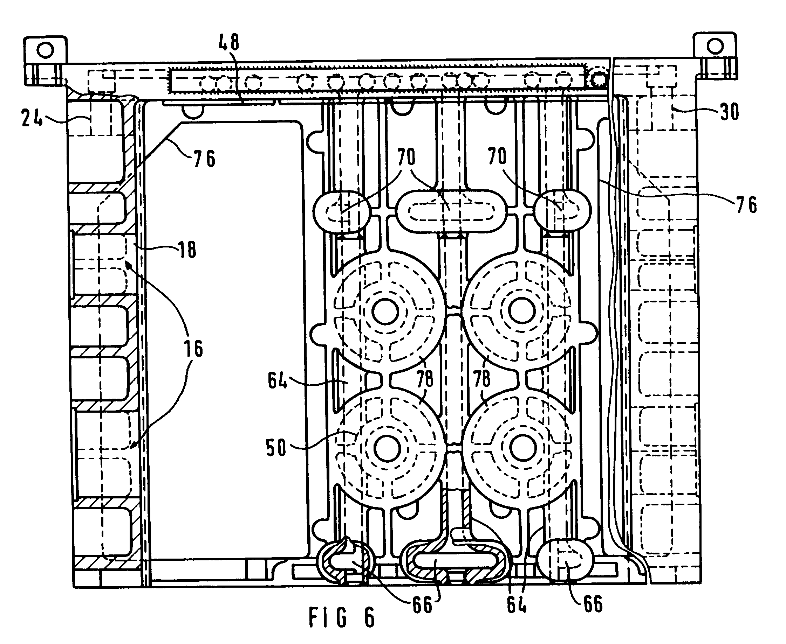

Die Figur 5 zeigt das Stromrichtermodul von links ohne Leistungsanschlüsse P, N und L, wobei in Figur 6 die Draufsicht auf die Vorderseite 8 des Stromrichtermoduls gezeigt wird. Die beiden Darstellungen sind teilweise geschnitten, um das Wesentliche zu erkennen. Die Kühlflüssigkeit Wasser wird über den Anschluß 24 der waagerechten Kühlkanalplatte 48 zugeführt. Die Flüssigkeit Wasser gelangt über einen Flüssigkeit-Einlaufsammler 62 (Figur 7) für die senkrechte Kühlkanalplatte 50 zu den Kühlkanälen 64 dieser Kühlkanalplatte 50. Am unteren Ende dieser Kühlkanäle 64 sind Anschlußbereiche 66 für die Wasserrohre bzw. Kühlschläuche 52 vorgesehen. Gemäß der Punkt-Strich-Linie 68 können die Wasserrohre 52 zwischen den Anschlußbereichen 66 der Kühlkanäle 64 und den Kühldosen 46 des ersten Spannverbandes 42 verlaufen. Wie bereits erwähnt, sind die Kühldosen 46 der beiden Spannverbände 42 und 44 untereinander mit Kühlschläuchen 52 verbunden, deren Verläufe mittels der Punkt-Strich-Linie 68 angedeutet sind. Von den Kühldosen 46 des zweiten Spannverbandes 44 gelangt das Kühlmedium Wasser wieder mittels Wasserrohren 52, die jeweils mit einem Anschlußbereich 70 eines Kühlkanals 72 der senkrechten Kühlkanalplatte 50 verbunden sind, damit die Kühlflüssigkeit Wasser in einen Verteilsammler 74 (Figur 7) für die waagerechte Kühlkanalplatte 48 gelangt. Die Querschnittfläche der Kühlkanäle 64 und 72 können kreis-, oval-, dreieck- oder rechteckförmig ausgebildet sein. Die Fließrichtung des Kühlmediums Wasser wird in den Figuren 5 und 7 jeweils mit Pfeilen gekennzeichnet. Durch die Verwendung von Kühlschläuchen bzw. Wasserrohren 52 wird die Innenluft des Stromrichtermoduls ebenfalls gekühlt.

Wie der Darstellung der Vorderseite 8 des Stromrichtermoduls gemäß Figur 6 zu entnehmen ist, weist diese Vorderseite 8 zwei Ausnehmungen 76 auf, die derart verteilt sind, daß die Vorderseite 8 einen Mittelteil aufweist, der zur senkrechten Kühlkanalplatte 50 ausgearbeitet ist. Diese Ausnehmung 76 in der Vorderseite 8 des Stromrichtermoduls dient einerseits der besseren Zugänglichkeit ins Innere des Moduls und andererseits der Durchführung von elektrischen Leitungen von einer nicht näher dargestellten Ansteuerbaugruppe (Gate-Unit) . Diese Ausnehmungen 76 werden mit Abdeckungen 32 verschlossen, wobei diese Abdeckungen 32 gleichzeitig als Tragplatten für die Ansteuerbaugruppen dienen. Außerdem ist die senkrechte Kühlkanalplatte 50 mit Bereichen 78 versehen, die für die Befestigung und Kühlung der Kondensatoren C1, C2 vorgesehen sind.

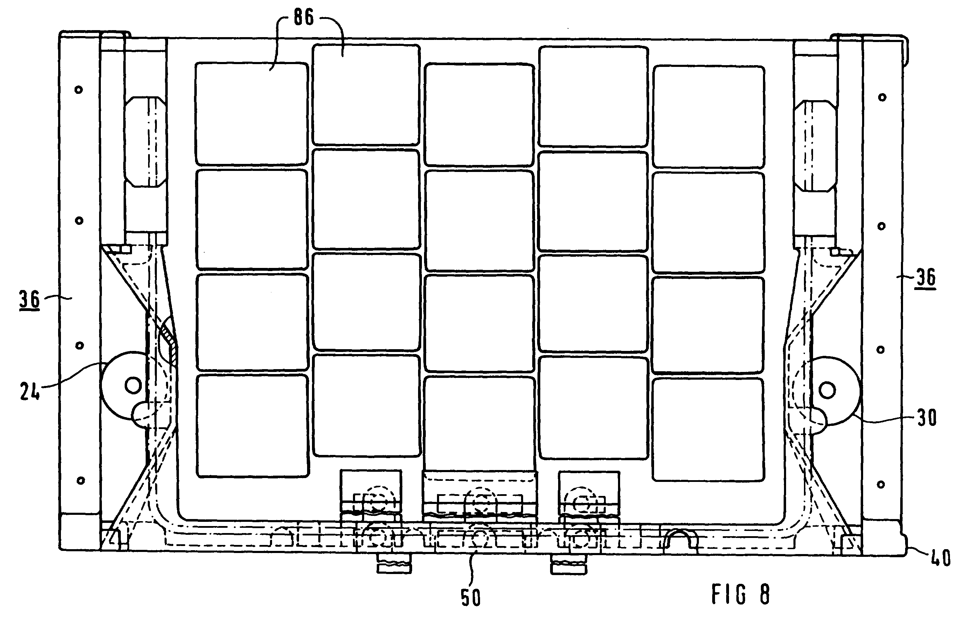

Die Figur 7 zeigt eine Draufsicht auf die Oberseite 34 des Stromrichtermoduls. Diese Oberseite 34, deren Innenseite in der Figur 8 näher dargestellt ist, ist als waagerechte Kühlkanalplatte 48 ausgebildet. Dazu sind mehrere Kühlkanäle 80 jeweils mäanderförmig in der Oberseite 8 des Stromrichtermoduls verlegt. Jeder Kühlkanal 80 beginnt im Verteilsammler 74 und mündet in einem Rücklaufsammler 82. Der Rücklaufsammler 82 ist über einen Verbindungskanal 84 mit dem Anschluß 30 für die Abführung der Kühlflüssigkeit verbunden. Die Kühlflüssigkeit Wasser gelangt von den Kühldosen 46 des zweiten Spann verbandes 44 kommend über die Kühlkanäle 72 in den Verteilsammler 74, von wo aus das Wasser gleichzeitig durch die mehreren mäanderförmig geführten Kühlkanäle 80 in den Rücklauf sammler 82 strömt. Von dort fließt das Wasser über den Verbindungskanal 84 und den Anschluß 30 in das Abflußrohr 56 der Wasserversorgung. Auch bei dieser Darstellung ist die Fließrichtung des Kühlmediums Wasser durch Pfeile gekennzeichnet.

Gemäß der Figur 8 ist die Innenseite der Oberseite 34 des Gehäuses 2 mit mehreren nebeneinander angeordneten viereckigen Montagesockel 86 versehen. Diese Montagesockel 86 können auch zu einer Fläche für mehrere Widerstände zusammengefaßt werden. Jeder Montagesockel 86 dient zur Aufnahme eines niederinduktiven Widerstandes. All diese Widerstände sind elektrisch parallel zu dem Widerstand Rs geschaltet, der die in den Drosseln L1, L2 gespeicherte Energie in Wärme umsetzen muß.

Durch die erfindungsgemäße Ausgestaltung des Gehäuses 2 des Stromrichtermoduls kann als Kühlmedium unbehandeltes Wasser beliebiger Leitfähigkeit mit den damit verbundenen Vorteilen verwendet werden, ohne dabei für die Beschaltungselemente, wie Kondensatoren C1, C2, Drosseln L1, L2 und den Widerstand Rs eine Luftkühlung verwenden zu müssen. Somit erhält man ein wassergekühltes Stromrichtermodul, das vollständig gekapselt ist, das heißt, es gelangt keine Kühlluft an die elektrischen Bauelemente V1 bis V6, L1, L2, C1, C2 und Rs der Stromrichterschaltung.

Die Vorteile bei Verwendung von Wasser als Kühlmittel gegenüber Öl oder anderen Kühlmedien sind unter anderem
- sehr gute Kühlwirkung durch große Wärmekapazität
- die Verfügbarkeit
- nicht brennbar
- umweltfreundlich
- geringe Kosten

Die Kühlung mit Wasser bringt für die Stromrichter folgende Vorteile:
- kompakte Bauweise, dadurch
- höhere Stromrichterleistungen, damit
- leistungsbezogene Gewichts- und Volumenreduzierung
- geringe Verschmutzung
- geringer Wartungsaufwand.

Mittels solcher wassergekühlter Stromrichtermodule können Stromrichter hoher Leistung in äußerst kompakter Bauweise aufgebaut werden. Dabei dient das wassergekühlte Stromrichtermodul jeweils als Phasenbaustein sowohl im Eingangs- als auch im Ausgangsstromrichter, wodurch man einen kompakten und übersichtlichen Aufbau des Gesamtstromrichters erhält.

## Patentansprüche

1. Stromrichtermodul mit einem metallischen, allseitig geschlossenen Gehäuse (2), in dem Stromrichterventile (V1, V2, V3, V4, V5, V6) sowie Beschaltungskomponenten, wie Drosseln (L1, L2), Kondensatoren (C1, C2) und ein Widerstand (Rs), angeordnet sind, wobei das Gehäuse (2) mit zwei Anschlüssen (24, 30) für die Zu- und Abführung des Kühlmediums sowie mit mehreren Leistungsanschlüssen (P, N,L) versehen ist, und wobei die Stromrichterventile (V1, V2, V3, V4, V5,V6) in einem Spannverband angeordnet sind, **dadurch gekennzeichnet**, daß das Gehäuse (2) aus einem mehrseitig geöffneten Gehäuseteil und mehreren Abdeckungen (32) besteht, wobei dieses Gehäuseteil zwei Seitenwände (10), eine Vorderseite (8) und eine Oberseite (34) aufweist, daß ein Mittelteil der Vorderseite (8) und die Oberseite (34) jeweils als Kühlkanalplatte (48, 50) ausgebildet sind, an denen die Beschaltungskomponenten (C1, C2, Rs) befestigt sind, daß die Stromrichterventile (V1, V2; V3, V4, V5, V6) des Spannverbandes mit Kühldosen (46) versehen sind, daß diese Kühldosen (46) und die Kühlkanalplatten (48, 50) des Gehäuseteils mittels Kühlleitungen (52) ein in sich geschlossenes Kühlsystem bilden, und daß als Kühlmedium Wasser verwendet wird.

2. Stromrichtermodul nach Anspruch 1, **dadurch gekennzeichnet**, daß die Stromrichterventile (V1, V2; V3, V4, V5, V6) auf zwei zwischen den Seitenwänden (10) des Gehäuseteils angeordneten Spannverbänden (42, 44) aufgeteilt sind.

3. Stromrichtermodul nach Anspruch 1, **dadurch gekennzeichnet**, daß als Leistungsanschlüsse (P, N, L) großflächige Stromschienen vorgesehen sind, wobei die Leistungsanschlüsse (P, N) mit kleinem Abstand auf der Rückseite (4) in der Modulmitte und der Leistungsanschluß (L) auf der Vorderseite (8) des Gehäuses (2) angeordnet sind.

4. Stromrichtermodul nach Anspruch 1, 2 oder 3, **dadurch gekennzeichnet**, daß die Anschlüsse (24, 30) für die Zu- und Abführung des Kühlmediums jeweils mit einem beidseitig selbstsperrenden Schnellverschluß (26) versehen sind.

5. Stromrichtermodul nach einem der Ansprüche 1 bis 4, **dadurch gekennzeichnet**, daß das Gehäuseteil des Gehäuses (2) beidseitig an der Oberseite (34) jeweils mit einer Tragschiene (36) und einer Arretierungsvorrichtung (40) versehen ist.

6. Stromrichtermodul nach einem der vorgenannten Ansprüche 1 bis 5, **dadurch gekennzeichnet**, daß die Kühlkanalplatte (50) des Mittelteils der Vorderseite (8) und die Kühlkanalplatte (48) der Oberseite (34) jeweils mehrere Kühlkanäle (64, 72, 80) aufweisen, wobei jeder Kühlkanal (80) der Oberseite (34) zwischen einem Verteilsammler (74) und einem Rücklauf sammler (82) mäanderförmig geführt ist.

7. Stromrichtermodul nach einem der Ansprüche 1 bis 6, **dadurch gekennzeichnet**, daß die Innenseite der Oberseite (34) des Gehäuses (2) in mehreren nebeneinander angeordneten viereckigen Tragplatten (86) unterteilt ist.

8. Stromrichtermodul nach einem der vorgenannten Ansprüche 1 bis 7, **dadurch gekennzeichnet**, daß jeder Kühlkanal (64, 72) der Kühlkanalplatte (50) der Vorderseite (8) mittels einer Kühlleitung (52) mit einer Kühldose (46) eines Spannverbandes (42, 44) verknüpft ist.

9. Stromrichtermodul nach Anspruch 5, **dadurch gekennzeichnet**, daß die Standfläche der Tragschiene (36) mit einem harten Kunststoff beschichtet ist, der einen sehr geringen Reibbeiwert aufweist.

10. Stromrichtermodul nach einem der Ansprüche 1 bis 9, **dadurch gekennzeichnet**, daß die Abdeckungen (32) der Vorderseite (8) des Gehäuses (2) mit Entlüftungs- und Durchführungsöffnungen versehen sind.

## Claims

1. Converter module having a metallic housing (2) which is closed on all sides and in which converter valves (V1, V2, V3, V4, V5, V6) as well as circuit components such as inductors (L1, L2), capacitors (C1, C2) and a resistor (Rs) are arranged, the housing (2) being provided with two connections (24, 30) for the inlet and outlet of the cooling medium and with a plurality of power connections (P, N, L), and the converter vales (V1, V2, V3, V4, V5, V6) being arranged in a clamping binding, characterized in that the housing (2) comprises a housing part, which is open on a plurality of sides, and a plurality of covers (32), this housing part having two side walls (10), a front (8) and a top (34), in that a centre part of the front (8) and the top (34) are in each case constructed as a cooling channel plate (48, 50) on which cooling channel plates (48, 50) the circuit components (C1, C2, Rs) are mounted, in that the converter valves (V1, V2; V3, V4, V5, V6) of the clamping binding are provided with cooling containers (46), in that these cooling containers (46) and the cooling channel plates (48, 50) of the housing part form, by means of cooling lines (52), a cooling system which is intrinsically closed, and in that water is used as the cooling medium.

2. Converter module according to Claim 1, characterized in that the converter valves (V1, V2; V3, V4, V5, V6) are split between two clamping bindings (42, 44) which are arranged between the side walls (10) of the housing part.

3. Converter module according to Claim 1, characterized in that large-area busbars are provided as power connections (P, N, L), the power connections (P, N) being arranged with a small separation on the rear (4) in the module centre, and the power connection (L) being arranged on the front (8) of the housing (2).

4. Converter module according to Claim 1, 2 or 3, characterized in that the connections (24, 30) for the inlet and outlet of the cooling medium are each provided with a quick-release closure (26) which is self-closing on both sides.

5. Converter module according to one of Claims 1 to 4, characterized in that the housing part of the housing (2) is provided with a supporting rail (36) and a locking device (40) on each of the two sides at the top (34).

6. Converter module according to one of the above-mentioned Claims 1 to 5, characterized in that the cooling channel plate (50) of the centre part of the front (8) and the cooling channel plate (48) of the top (34) each have a plurality of cooling channels (64, 72, 80), each cooling channel (80) of the top (34) being routed in a meandering shape between a distribution manifold (74) and a return manifold (82).

7. Converter module according to one of Claims 1 to 6, characterized in that the inside of the top (34) of the housing (2) is divided into a plurality of quadrilateral supporting plates (86) which are arranged alongside one another.

8. Converter module according to one of the above-mentioned Claims 1 to 7, characterized in that each cooling channel (64, 72) of the cooling channel plate (50) of the front (8) is linked by means of a cooling line (52) to a cooling container (46) of a clamping binding (42, 44).

9. Converter module according to Claim 5, characterized in that the standing surface of the supporting rail (36) is coated with a hard plastid which has a very low coefficient friction.

10. Converter module according to one of Claims 1 to 9, characterized in that the covers (32) of the front (8) of the housing (2) are provided with venting openings and through-flow openings.

## Revendications

1. Module convertisseur comportant un boîtier (2) métallique fermé de tous côtés dans lequel se trouvent des valves de convertisseur (V1, V2, V3, V4, V5, V6) et des composants de circuit tels que des bobines de self (L1, L2), des condensateurs (C1, C2) et une résistance (Rs), le boîtier (2) étant muni de deux raccords (24, 30) pour l'entrée et la sortie du fluide de refroidissement ainsi que de plusieurs bornes de puissance (P, N, L) et les valves de convertisseur (V1, V2, V3, V4, V5, V6) étant agencées dans un groupe de tension, caractérisé par le fait que le boîtier (2) est constitué d'une pièce de boîtier ouverte sur plusieurs côtés et de plusieurs caches (32), cette pièce de boîtier comportant deux parois latérales (10), une face avant (8) et un dessus (34), qu'une partie médiane de la face avant (8) et le dessus (34) sont construits sous forme de plaques de canaux de refroidissement (48, 50) auxquelles les composants de circuit (C1, C2, Rs) sont fixés, que les valves de convertisseur (V1, V2 ; V3, V4, V5, V6) du groupe de tension sont munies de boîtes de refroidissement (46), que ces boîtes de refroidissement (46) et les plaques de canaux de refroidissement (48, 50) de la pièce de boîtier forment au moyen de conduits de refroidissement (52) un système de refroidissement fermé sur lui-même, et que de l'eau est utilisée comme fluide de refroidissement.

2. Module convertisseur selon la revendication 1, caractérisé par le fait que les valves de convertisseur (V1, V2 ; V3, V4, V5, V6) sont réparties sur deux groupes de tension (42, 44) agencées entre les parois latérales (10) de la pièce de boîtier.

3. Module convertisseur selon la revendication 1, caractérisé par le fait que des barres conductrices de grande surface sont prévues comme bornes de puissance (P, N, L), les bornes de puissance (P, N) étant agencées à une petite distance l'une de l'autre sur la face arrière (4) dans le milieu du module et la borne de puissance (L) étant agencée sur la face avant (8) du boîtier (2).

4. Module convertisseur selon la revendication 1, 2 ou 3, caractérisé par le fait que les raccords (24, 30) pour l'entrée et la sortie du fluide de refroidissement sont munis chacun d'un raccord à fermeture rapide (26) autobloquant des deux côtés.

5. Module convertisseur selon l'une des revendications 1 à 4, caractérisé par le fait que la pièce du boîtier (2) est munie des deux côtés, sur le dessus (34), d'une barre de support (36) et d'un dispositif d'arrêt (40).

6. Module convertisseur selon l'une des revendications précédentes 1 à 5, caractérisé par le fait que la plaque de canaux de refroidissement (50) de la partie médiane de la face avant (8) et la plaque de canaux de refroidissement (48) du dessus (34) comportent chacune plusieurs canaux de refroidissement (64, 72, 80), chaque canal de refroidissement (80) du dessus (34) s'étendant en forme de méandres entre un collecteur distributeur (74) et un collecteur de retour (82).

7. Module convertisseur selon l'une des revendications 1 à 6, caractérisé par le fait que la face intérieure du dessus (34) du boîtier (2) est divisée en plusieurs plaques de support (86) quadrangulaires agencées les unes à côté des autres.

8. Module convertisseur selon l'une des revendications précédentes 1 à 7, caractérisé par le fait que chaque canal de refroidissement (64, 72) de la plaque de canaux de refroidissement (50) de la face avant (8) est relié au moyen d'un conduit de refroidissement (52) à une boîte de refroidissement (46) d'un groupe de tension (42, 44).

9. Module convertisseur selon la revendication 5, caractérisé par le fait que la surface debout de la barre de support (36) est couverte d'une matière plastique dure qui a un très faible coefficient de frottement.

10. Module convertisseur selon l'une des revendications 1 à 9, caractérisé par le fait que les caches (32) de la face avant (8) du boîtier (2) sont munis d'ouvertures d'aération et de passage.
